# EUROPEAN PATENT APPLICATION

(11) **EP 1 158 845 A1**
(43) Date of publication of application: **28.11.2001**
(21) Application number: 00304439.3
(22) Date of filing: 25.05.2000
(51) Int. Cl.: H05K 7/14, H01R 13/631

(54) **Arrangement of components while maintaining required tolerances**

(71) Applicant: LUCENT TECHNOLOGIES INC., Murray Hill, New Jersey 07974-0636 (US)
(72) Inventor: Bauernschmidt, Georg, Gobweinstein 91327 (DE); Seib, Michael, Ansbach 91567 (DE)
(74) Representative: Williams, David John

(57) **Abstract**

To provide a more simple and cost-effective way of providing carrier modules while maintaining required narrow tolerance ranges of components to be assembled, in particular in the connecting region, the invention proposes a method of producing a module (2) with at least two carrier devices (6a, 6b) and a component (7b) to be positioned with the module in a tolerance-dependent manner as well as a contrivance suitable for carrying this out.

A component (7b) to be positioned in a tolerance-dependent manner on a carrier device (6b) is arranged by means of the contrivance designed according to the invention, with a device (8b) for holding the component, on the carrier device (6b) such that it is held in such a way that, for fixing a specific position of the component (7b), a separate fixing (9) of the contrivance is required, and the desired positioning after assembly of this and a further carrier device (6a, 6b) takes place by defined interaction of a device (8a, 9) of the contrivance with the further carrier device (6a).

## Description

The invention relates to a method of producing a module with at least two carrier devices and a component to be positioned with the module in a tolerance-dependent manner and relates to a contrivance suitable for carrying out the method and to a module which can be produced by the method.

Mechanical and/or electronic equipment or systems are often of a modular type of construction.

For example, in the production of electronic equipment, it is customary for individual components to be initially pre-assembled mechanically, and if appropriate also electrically, on carriers, such as printed-circuit boards for example. Subsequently, a plurality of units pre-assembled in this way to form assemblies are in turn combined to form individual modules, which for their part are in turn arranged in subracks, housings, racks and/or cabinets.

Full electrical interconnection between the individual assemblies is often not carried out until they are in the subracks. For the electrical contacting operations necessary for this purpose, components which are often designed as connectors and are pre-assembled on the printed-circuit board are provided, interacting with mating connectors of a complementary design provided by the subracks.

To ensure reliable contacting between the connectors and mating connectors at all times, even during a possible subsequent exchange of a module, narrow tolerance ranges, for example of a few tenths of a millimetre or less, have to be maintained during production or with regard to assembly of the individual assemblies, in particular in the connector region.

Depending on the specific configuration of the electronic equipment, in particular with respect to the dimensions and arrangements of the individual elements and their packing density, this requires on the one hand very precise manufacturing equipment and consequently results in to some extent very cost-intensive production. On the other hand, on account of very narrow tolerance ranges, in service work and/or in the case of repair, for example, reproducibility of the exact position of components to be connected to one another to ensure reliable contacting is often only possible with additional aids, such as gauges for example, and with great expenditure of time.

It is consequently the object of the invention to present a more simple and cost-effective way in which it is possible to provide carrier modules while maintaining required narrow tolerance ranges of components to be assembled, in particular in the connector region, and to allow tolerance-based component positions to be subsequently reproduced significantly more easily, in particular even manually.

The object is achieved by a method with the features of Claim 1 and by a contrivance and a module according to Claims 4 and 13, respectively.

The invention provides that, in the production or assembly of a module with at least two carrier devices, a component to be positioned in a tolerance-dependent manner on a carrier device is to be arranged by means of a correspondingly designed contrivance on the carrier device such that it is held in such a way that the desired positioning after assembly of this and a further carrier device takes place by defined interaction of the contrivance with the further carrier device, and, for fixing a specific position of the component, a separate fixing operation is carried out.

This ensures for the first time that a required precise positioning of components arranged on carriers, in particular for reliable electrical contacting of a connector element fastened on a printed-circuit board to a mating connector provided by a subrack, is not carried out until individual carriers have been joined together to form a module. An advantage of this is that, while using one carrier device as a reference device for the precise positioning of a component arranged on another carrier device, it is the case both that a no longer extremely precise arrangement, within prescribed tolerance limits, is adequate with regard to the pre-assembly of the position-dependent component on the carrier device and that there are less exacting requirements in the assembly of individual carrier devices to form a module with respect to their positions to be aligned exactly with respect to one another. Consequently, a good and extremely precise end product can be ensured even with no longer extremely precisely produced and/or assembled individual elements, it also being the case that quicker, and consequently more cost-effective, reproducibility of the exact positions of position-dependent components can be ensured and it is essentially possible to dispense with further aids.

In a preferred refinement it is provided for the device for holding the component on the desired carrier device to be fastened in a floating manner, to allow a precise alignment to be carried out in preferably all axes. Furthermore, it is of advantage if an electrical connection between the component and the carrier device holding it takes place via flexible lines. In addition, a releasable connection is provided in an advantageous way by means of a fixing device, for the dimensional assignment in the critical tolerance range, in order to simplify further any required (re-)positioning of the component at essentially any point in time.

To provide a particularly simple and inexpensive contrivance according to the invention, which nevertheless withstands the mechanical loads, said contrivance is made of metal and is designed essentially in the form of an angle, the one leg of which has the device for holding and the other leg of which has the fixing device.

In a particularly preferred development, depressions are formed for the precise positioning, which depressions are congruent with in each case an assigned internal thread, formed on a mating element, during the dimensional assignment in the critical tolerance range, so that fixing of the aligned position, including in the case of so-called "backplane-compatible" arrangements, by means of countersunk screws is made easier. Since unintentional damaging of the depressions is largely ruled out, the assignment achieved in this way is exact on an essentially permanent basis.

Further advantages are evident from the following description of the invention in detail, in particular on the basis of a preferred exemplary embodiment, with reference to the attached drawings, in which:
Figure 1 shows a greatly simplified representation of a module arranged in a subrack, with a contrivance according to the invention for the positionable holding of a component while maintaining prescribed tolerances,
Figure 2 shows a schematic general representation of a floating fastening of the contrivance according to the invention,
Figure 3 shows a section along the line A-A of Figure 2 and
Figure 4 shows an alternative and/or supplementary embodiment of a fastening of the contrivance according to the invention.

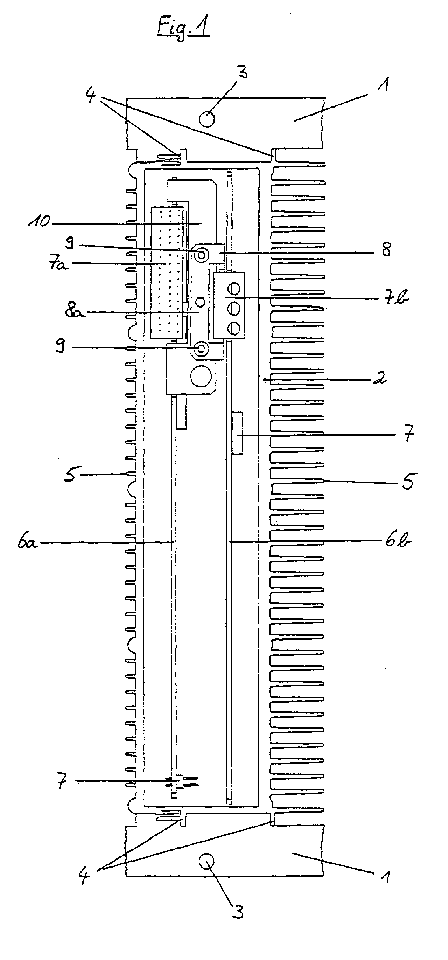

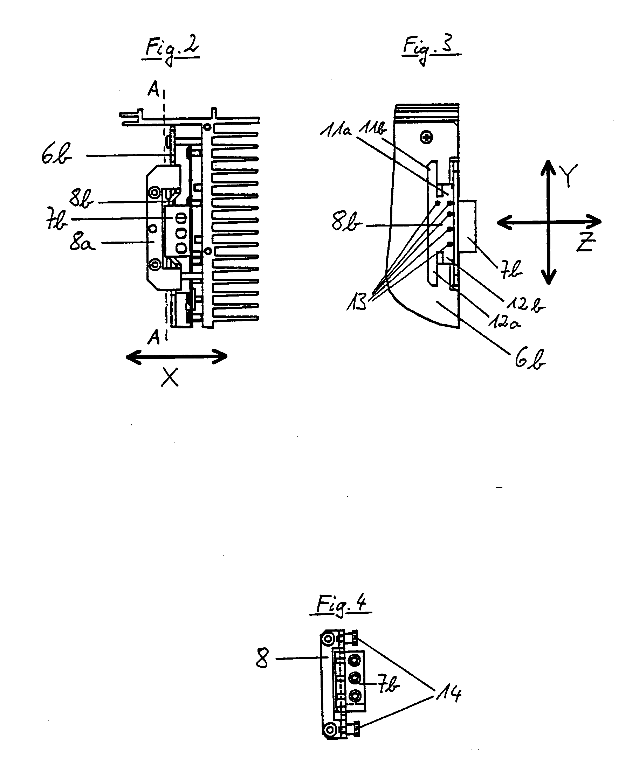

The invention is described below on the basis of an exemplary application, reference firstly being made to Figure 1. In Figure 1, an assembly module 2, comprising a plurality of mechanical and electronic elements and accommodated between two receiving units 1 of a subrack, is represented by way of example in a greatly simplified form. The subrack represented has fastening devices 3 and is part of a mechanical assembly and wiring system, not depicted or described in any more detail, of an item of electronic equipment, which may be designed to be of essentially any size and for essentially any use.

The assembly module 2 is designed as a slide-in unit and has, for receiving purposes, correspondingly designed guides 4 between the two receiving units 1. Furthermore, for improved heat dissipation for the temperatures induced by the electronic elements, cooling ribs 5 are arranged on two opposite surfaces of the module 2.

In the module 2 there are carrier devices, in the present case two printed-circuit boards 6a and 6b, arranged in essentially a predetermined position with respect to one another and mechanically connected to the module 2 in a way conventional for a person skilled in the art in this area. On the printed-circuit boards 6a, 6b there are various components 7, 7a which, depending on the specific type, are mechanically pre-assembled, such as surface-mounted or plugged, and/or electrically pre-assembled, for example by means of wiring or soldered via contact areas, and if appropriate are connected to one another. The component 7a, for example, represents a multipin plug-in connector, which is mechanically and electrically connected to the printed-circuit board 6a and is mechanically and electrically interconnected with an assigned mating plug-in connector, which is provided by the subrack but is not represented for reasons of overall clarity, for supplying signals to individual components and/or assemblies.

A further component 7b, designed in the exemplary embodiment as a three-pin plug-in connector, is arranged on the printed-circuit board 6b and is likewise mechanically and electrically interconnected with an assigned mating plug-in connector which is provided by the subrack but is not represented, in the present exemplary embodiment for supplying voltage to individual components and/or assemblies.

In order that reliable electrical contacting between the components designed as being respectively complementary is ensured with regard to the interconnection, the arrangement of the mating connectors provided usually prescribes the dimensional assignment of the connectors 7a and 7b arranged correspondingly on the printed-circuit boards 6a and 6b.

As a departure from the previously performed precise arrangement already during the pre-assembly of the components on the carrier units before they are accommodated in a modular manner in corresponding subracks, the dimensional assignment and corresponding alignment of the exact position of the component 7b arranged on the printed-circuit board 6b can still be carried out, according to the invention, after the module 2 has been received in the subrack.

For this purpose, the connector 7b represented in the exemplary embodiment according to Figure 1 is held in a floating manner (for example according to Figures 2 and 3) on the printed-circuit board 6b by means of a component 8 which is fastened on the printed-circuit board 6b and is designed essentially in the form of an angle. The component 8 has, furthermore, two passages 9 on the leg 8a extending at an angle with respect to the printed-circuit board 6b. Fastened on the printed-circuit board 6a is a mating element 10, which comprises two internal threads (not represented) in a region adjacent to the angle leg 8a.

The passages 9 are arranged and designed with respect to the internal threads in such a way that a releasable connection can be established between the printed-circuit boards 6a and 6b, even after their arrangement in the module 2, by means of the components 8 and 10. In the present example, the passages 9 are designed as conical depressions and the releasable connection takes place by using countersunk screws.

Consequently, the dimensional assignment of the connector 7b on the printed-circuit board 6b required for reliable electrical contacting between the connector 7b and the assigned mating connector provided can be carried out in the critical tolerance range of, for example, 0.05 mm by means of the components 8 and 10 with reference to the printed-circuit board 6a.

Consequently, an exact positioning with subsequent fixing, which is suitable even for a precise "backplane-compatible" multiple connector arrangement, is ensured just by the use of components and their corresponding design, without meeting extremely precise requirements. Moreover, the accuracy remains permanently high, even after repeated release of the connection, since the depressions 9 can scarcely be damaged unintentionally.

Electrical connections, not represented however, between the connector 7b and the printed-circuit board 6b are established via flexible lines, in particular not to hinder an adjustment-of the connector 7b. The angle element 8 and the mating element may be produced from plastic or a metal-containing material, in order to withstand even relatively great mechanical loads.

One possible type of floating fastening of a positionable component according to the invention arranged on a carrier device is schematically presented in Figures 2 and 3, components which are the same or act in the same way being assigned the same reference numerals.

In addition to the leg 8a described above, the angle element 8 according to Figures 2 and 3 comprises a leg 8b, which is designed for holding the component 7b and for the floating fastening of the component 7b on the carrier device 6b. On two opposite sides, the leg 8b has regions 11 and 12, with in each case a relief arranged between two lugs 11a, 11b and 12a, 12b. The relief may be made, for example, by punching out. The lugs 11a and 11b or 12a and 12b are respectively formed oppositely in such a way that the regions 11 and 12 are designed essentially in the form of a V transversely to the plane of the leg 8b. The component 7b to be positioned in a tolerance-dependent manner is fastened onto a remaining region of the leg 8b, for example by customary fastening means 13.

Furthermore, the carrier device 6b has a relief which is approximately the size of the remaining region of the leg 8b and into which the leg 8b can be introduced in such a way that its V-shaped reliefs receive regions of the carrier device 6b and, in this way, the angle element 8 is held on the printed-circuit board 6b.

Depending on the specific application and in a way corresponding to the desired shaping of the angle regions 11 and 12 and of the carrier device 6b, the angle element 8 is consequently fastened in a floating manner in one, two or preferably in all three axes X, Y and Z within a prescribable range, for example of approximately 0.5 mm in all axes. The component 7b held by means of the angle element 8 can consequently still be exactly positioned after the modular arrangement of the carrier units 6a and 6b and can subsequently be fastened and fixed in the desired position, in the present example by means of the leg 8a.

In an alternative or supplementary way, the holding element 8 can, for example, also be fastened, as sketched in Figure 4, such that it can be aligned with the leg 8b on the carrier device 6b by means of corresponding clamping, screwing or pin-type connecting devices 14, this providing an additional possibility, if appropriate, for pre-centering of the component 7b to be positioned and/or for its fixing.

It should be mentioned that, furthermore, a mating element 10, as described with reference to Figure 1, may comprise devices for pre-centering and/or for relieving the weight of components to be positioned in a tolerance-dependent manner. According to the invention, however, it is also possible to dispense with the additionally arranged mating element 10 and to use the carrier device 6b itself for the positioning and/or subsequent fixing 9 of the component.

## Claims

1. Method of producing a module (2) comprising at least two carrier devices (6a, 6b) and a component (7b) to be positioned with the module in a tolerance-dependent manner, which comprises the method steps of:
a) assembling the first carrier device (6a),
b) arranging the component (7b) on the second carrier device (6b), using a contrivance (8) which can be connected to the second carrier device and is intended for holding the component,
c) assembling the second carrier device (6b) in a predetermined position with respect to the first carrier device (6a),
d) positioning the component (7b) on the second carrier device (6b), using a defined interaction of the contrivance with the first carrier device (6a),
e) fixing the contrivance (8) for the fixable positioning of the component (7b) on the second carrier device (6b).

2. Method according to Claim 1, the steps a) and b) being carried out in the reverse order.

3. Method according to Claim 1 or 2, **characterized in that** flexible lines are used for establishing an electrical connection between the component (7b) and the second carrier device (6b).

4. Contrivance for the tolerance-dependent positioning of a component (7b), which is arranged on a second carrier device (6b), which is fixed in a predetermined position with respect to a first carrier device (6a), comprising:
- a device (8b) which can be connected to the second carrier device (6b) and is intended for holding the component on this carrier device,
- a device (8a, 9) which interacts with the first carrier device (6a) and is intended for positioning the component (7b) on the second carrier device (6b),
- at least one fixing device (8a, 9) for the fixable positioning of the component (7b) on the second carrier device (6b).

5. Contrivance according to Claim 1, **characterized in that** the device (8b) for holding the component can be fastened in a floating manner on the second carrier device.

6. Contrivance according to one of Claims 4 or 5, **characterized in that** the fixing device (8a, 9) provides a releasable connection.

7. Contrivance according to one of Claims 4 to 6, which comprises a device (8a, 9) which interacts directly with the first carrier device (6a) as a mating element.

8. Contrivance according to one of Claims 4 to 6, which comprises a device (8a, 9) which interacts with a mating element (10) fastened on the first carrier device (6a).

9. Contrivance according to Claim 7 or 8, **characterized in that** the device (8a, 9) for positioning comprises at least one conical depression, which is intended for receiving in particular countersunk screws and, during positioning in the critical tolerance range, is congruent with in each case an assigned internal thread formed on the mating element.

10. Contrivance according to one of Claims 4 to 9, **characterized in that** the device (8b) for holding the component comprises a device (14) for pre-centering.

11. Contrivance according to one of Claims 4 to 10, **characterized in that** the contrivance is designed in the form of an angle (8), the one leg of which comprises the device for holding (8b) and the other leg of which comprises the device for positioning and the fixing device (8a, 9).

12. Contrivance according to one of Claims 4 to 11, **characterized in that** the contrivance is made of metal.

13. Module (2) with at least two carrier devices (6a, 6b) arranged in an essentially defined position with respect to one another, comprising a contrivance, in particular according to one of Claims 4 to 12, which is designed for the positioning of a component (7b) arranged on the module (2) and is intended for interacting with the first carrier device (6a) and, for holding the component (7b), is fastened on the second carrier device (6b).

14. Module according to Claim 13, **characterized in that** the contrivance is designed in the form of an angle (8), the one leg (8b) of which is designed for the floating fastening of the component (7b) on the second carrier device (6b) and the other leg (8a) of which has at least one conical depression (9), and **in that** on the first carrier device (6a) there is arranged a mating element (10) with in each case an internal thread assigned to a depression (9), in order to permit a screwed connection between the first carrier device (6a) and the second carrier device (6b).

15. Module according to Claim 14, **characterized in that** the. mating element (10) comprises devices for assembly pre-centring and/or relieving the weight of the component (7b).

16. Module according to Claim 13, 14 or 15, **characterized in that** the component (7b) is designed as a connector, in particular as a plug-in connector, which can be connected to a mating connector provided in a subrack.

17. Module according to one of Claims 13 to 16, which comprises flexible lines for establishing an electrical connection between the component (7b) and the second carrier device (6b).
